# EUROPÄISCHE PATENTSCHRIFT

(11) **EP 2 029 940 B1**
(45) Veröffentlichungstag und Bekanntmachung des Hinweises auf die Patenterteilung: **28.07.2010**
(21) Anmeldenummer: 07729212.6
(22) Anmeldetag: 16.05.2007
(51) Int. Cl.: F24C 3/12, H03K 17/96

(54) **VERFAHREN ZUR HERSTELLUNG EINES BLENDENTEILS FÜR EIN BEDIENPANEL MIT BERÜHRUNGSEMPFINDLICHEN SENSORTASTEN, INSBESONDERE FÜR EIN HAUSHALTSGERÄT**
METHOD FOR PRODUCING A PANEL PART FOR A CONTROL PANEL WITH TOUCH-SENSITIVE SENSOR KEYS, IN PARTICULAR FOR DOMESTIC APPLIANCES
PROCÉDÉ DE FABRICATION D'UNE PARTIE D'ÉCRAN POUR UN PANNEAU DE COMMANDE COMPRENANT DES TOUCHES À EFFLEUREMENT TACTILE, NOTAMMENT POUR UN APPAREIL MÉNAGER

(30) Priorität: 30.05.2006 DE 102006025141
(43) Veröffentlichungstag der Anmeldung: 04.03.2009
(73) Patentinhaber: BSH Bosch und Siemens Hausgeräte GmbH, 81739 München (DE)
(72) Erfinder: GÜNTER-FELSKE, Hans, 12105 Berlin (DE)
(86) Internationale Anmeldenummer: PCT/EP2007/054764
(87) Internationale Veröffentlichungsnummer: WO 2007/137943

(56) Entgegenhaltungen:
- EP-A- 1 122 753
- EP-A- 1 553 610
- EP-A2- 0 406 845
- US-A1- 2005 134 116

## Beschreibung

Die Erfindung betrifft ein Verfahren zur Herstellung eines Blendenteils für ein Bedienpanel mit berührungsempfindlichen Sensortasten, insbesondere für ein Haushaltsgerät; mit den Merkmalen des Oberbegriffs des Patentanspruchs 1 so wie ein Blendenteil für ein solches Bedienpanel mit den Merkmalen des Oberbegriffs des Patentanspruchs 7.

Bedienpanel bei moderneren Haushaltsgeräten weisen neuerdings berührungsempfindliche Sensortasten für die Bedienung des Geräts auf. Berührungsempfindliche Sensortasten weisen gegenüber herkömmlichen mechanischen Tasten den Vorteil einer deutlich geringeren Empfindlichkeit gegen Umwelteinflüsse, insbesondere Feuchtigkeit auf, da ein mit Sensortasten ausgebildetes Bedienpanel bzw. eine solch ausgestattete Bedienblende keine Öffnungen für mechanische Tasten benötigt und somit geschlossen ausgebildet werden kann. Bekannte kapazitive Sensortasten werden mittels eines Blendenteils für das Bedienpanel hergestellt, wobei an der Rückseite des Blendenteils ein Führungselement vorgesehen ist, in welchem ein Element aus leitendem Kunststoff gehalten ist. Die Unterseite des Elements aus leitendem Kunststoff steht mit einem Kontakt einer Leiterplatte in Verbindung, auf welcher zumindest ein Teil der Steuerungselektronik vorgesehen ist. Durch das Element aus leitendem Kunststoff wird das Potential der Elektrode bis knapp unter die Oberfläche des Bedienpanels herangeführt, wobei die Dicke des Bedienpanels so gewählt ist, dass sich auch an der Oberfläche des Bedienpanels in einem Bedienbereich eine Änderung der Kapazität bzw. einer anderen elektrischen oder optischen Eigenschaft ergibt, die im Sinne eines Aktivierens der berührungsempfindlichen Sensortaste detektierbar ist.

Derartige Blendenteile müssen dabei so hergestellt werden, dass der Bedienbereich der betreffenden berührungsempfindlichen Sensortasten optisch und/oder haptisch erkennbar ist. Hierzu ist es bekannt, auf der Oberfläche des Blendenteils den Bedienbereich der Sensortasten oder eine entsprechende Begrenzung des Bedienbereichs erhaben vorzusehen. Beispielsweise kann der Bedienbereich durch einen erhabenen Wulst, der als geschlossene Kurve verläuft, gekennzeichnet sein. Ein derartiger Wulst wird durch eine entsprechend gestaltete Kunststoffspritzform für das Herstellen des Blendenteils erzeugt, wobei die Spritzform eine zu dem gewünschten Wulst komplementäre Nut aufweist.

Dies führt jedoch zu dem Nachteil, dass für unterschiedliche Blendenteile mit unterschiedlich gestalteten berührungsempfindlichen Sensortasten oder einer verschiedenen Anzahl von berührungsempfindlichen Sensortasten jeweils eine separate Spritzform erforderlich ist. Dies führt zu hohen Herstellungskosten.

Bedienpanele mit Tasten zur Bedienung von PC-Tastaturen und Mobiltelefonen und Verfahren zur dessen Herstellung sind beispielsweise aus EP 1 122 753 A2 bekannt. In einer offenbarten Ausgestaltung solcher Bedienpanele ist ein Blendenteil vorgesehen, in dessen Oberfläche eine Nut um einen Bedienbereich ausgebildet ist, in welche eine Tastenkappe eingesetzt ist, die zugleich den Bedienbereich markiert.

Weitere Bedienpanele unter anderem mit berührungsempfindlichen Sensortasten und mit Markierungselementen für Bedienbereiche sind auch in EP 406 845 A2, US 2005/134116 A1 und EP 1 553 610 A1 offenbart.

Der Erfindung liegt daher die Aufgabe zugrunde, ein Blendenteil für ein Bedienpanel mit berührungsempfindlichen Sensortasten, insbesondere für ein Haushaltsgerät, und ein Verfahren zur Herstellung eines solchen Blendenteils zu schaffen, welches die einfache und kostengünstige Herstellung verschieden ausgestalteter Blendenteile ermöglicht.

Die Erfindung löst diese Aufgabe mit den Merkmalen des Patentanspruchs 1 bzw. des Patentanspruchs 7.

Die Erfindung geht von der Erkenntnis aus, dass durch das nachträgliche Kenntlich-Machen des Umrisses des Bedienbereichs mittels des Verbindens wenigstens eines Markierungselements mit der Oberfläche des Blendenteils nach dessen Herstellung eine drastische Kostenreduzierung erreichbar ist, wenn unterschiedliche Blendenteile, beispielsweise für verschiedene Typen von Geräten gefertigt werden müssen.

Nach einer Ausführungsform der Erfindung kann in der Oberfläche des Blendenteils eine Nut vorgesehen sein, in welche das wenigstens eine Markierungselement eingesetzt wird. Die Nut kann dabei vorzugsweise als geschlossene Nut vorgesehen sein, die den Bedienbereich umgibt.

Eine derartige Nut kann mit ein und demselben Spritzwerkzeug hergestellt werden, wenn im Spritzwerkzeug an den betreffenden Positionen der Wandung erhabene Elemente mit einer komplementären Struktur befestigt werden. Es kann somit ein und dasselbe Spritzwerkzeug für die Herstellung unterschiedlicher Blendenteile eingesetzt werden.

Es besteht auch die Möglichkeit, dass ein Basisblendenteil mit der maximalen Anzahl von berührungsempfindlichen Sensortasten hergestellt wird, wobei lediglich in die Nuten, welche die Bedienbereiche der tatsächlich benötigten Sensortasten Markierungselemente eingesetzt werden. In die übrigen Nuten können dann Blindelemente eingesetzt werden, die beispielsweise an der Oberfläche die selbe Farbe wie das übrige Blendenteil aufweisen und die vorzugsweise nach dem Einsetzen mit der Oberfläche des Blendenteils fluchten.

Nach einer Ausführungsform der Erfindung kann das Verbinden des wenigstens einen Markierungselements mit der Oberfläche des Blendenteils durch eine Rastverbindung des Markierungselements mit der Nut erfolgen. Hierdurch ergibt sich eine einfache und schnelle Montage.

Nach einer anderen Ausführungsform der Erfindung kann das Verbinden des wenigstens einen Markierungselements mit der Oberfläche des Blendenteils durch Verkleben mit der die Nut bildenden Wandung, vorzugsweise dem bodenseitigen Bereich der Wandung, erfolgen.

Das Verbinden des wenigstens einen Markierungselements mit der Oberfläche des Blendenteils kann nach einer weiteren Ausgestaltung der Erfindung auch durch Verschweißen des Markierungselements mit der die Nut bildenden Wandung, vorzugsweise dem bodenseitigen Bereich der Wandung der Nut erfolgen.

Als Schweißverfahren können beispielsweise das Ultraschallschweißen oder Laserschweißen eingesetzt werden. Im Fall des Ultraschallschweißens kann an der Unterseite des wenigstens einen Blendenteils ein Schweißwulst vorgesehen sein, der nach dem Einsetzen des Markierungselements mit der bodenseitigen Wandung der Nut in Berührung steht und der während des Schweißvorgangs erweicht und nach dem Erhärten die Schweißverbindung erzeugt. Anstelle eines Schweißwulstes können selbstverständlich auch Schweißpunkte verwendet werden.

Das Verschweißen des wenigstens einen Markierungsteils durch Laserschweißen kann nach einer Ausgestaltung der Erfindung von der Rückseite des Blendenteils her erfolgen. Hierzu weist das Blendenteil an der dem Bedienbereich abgewandten Seite einen optisch transparenten Bereich auf, der sich zumindest in einem Teilbereich im Wesentlichen bis an die Wandung der Oberfläche des Blendenteils heran erstreckt, in welchem die Schweißverbindung hergestellt wird. Auf diese Weise kann die Einstrahlung des Laserlichts von der Rückseite her erfolgen, wobei die Laserstrahlung in den optisch transparenten Bereich eingekoppelt und bis an die Schweißstelle herangeführt wird. Das Laserlicht wird in ausreichendem Maß erst in der restlichen Wandung des Blendenteils und/oder in dem wenigstens einen Markierungselement absorbiert, so dass diese Bereiche aufgeschmolzen bzw. erweicht werden und auf diese Weise die Schweißverbindung erzeugbar ist. Für das Verschweißen genügt es, das Markierungselement an einigen, beispielsweise drei Punkten mit dem Blendenteil zu verschweißen.

Weitere Ausgestaltungen der Erfindung ergeben sich aus den Unteransprüchen. Die Erfindung wird nachfolgend anhand in der Zeichnung dargestellter Ausführungsbeispiele näher erläutert. In der Zeichnung zeigen:
- Fig. 1: einen teilweisen Schnitt duch ein Bedienpanel mit einem Blendenteil, her- gestellt nach einem ersten Ausführungsbeispiel des erfindungsgemäßen Verfahrens (Fig. 1 a) sowie eine Draufsicht auf das Bedienpanel (Fig. 1 b) und
- Fig. 2: einen teilweisen Schnitt durch ein Bedienpanel, hergestellt nach einer wei- teren Ausführungsform des erfindungsgemäßen Verfahrens (Fig. 2a) sowie eine Draufsicht auf das Bedienpanel (Fig. 2b) und eine ausschnittsweise Vergrößerung des in das Blendenteil eingesetzten Markierungselements (Fig. 2c).

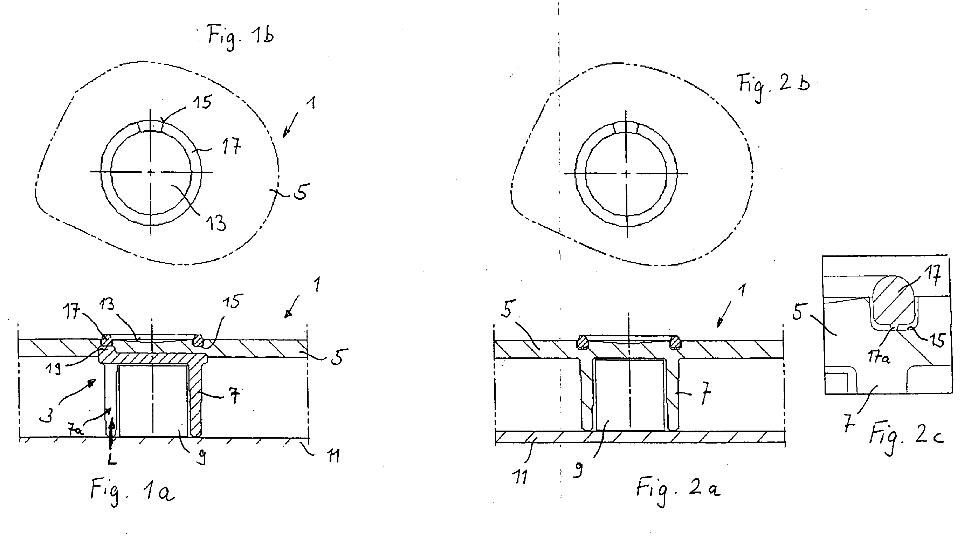

Das in Fig. 1 im Teilschnitt dargestellte Bedienpanel 1, das beispielsweise für ein Haushaltsgerät vorgesehen sein kann, weist im dargestellten Ausschnitt eine berührungsempfindliche Sensortaste 3 auf. Selbstverständlich kann das Bedienpanel insgesamt mehrere derartige berührungsempfindliche Sensortasten umfassen. Das Bedienpanel 1 besteht aus einem Blendenteil 5, welches mit einem Halteelement 7 für ein Leiterelement 9 verbunden ist. Sowohl das Blendenteil 5 als auch das Halteelement 7 können aus Kunststoff bestehen. Blendenteil 5 und Halteelement 7 können durch Zweikomponenten-Kunststoffspritzen hergestellt werden. Selbstverständlich kann die Herstellung dieser Einheit auch dadurch erfolgen, dass das Haltelement 7 in das Blendenteil 5 eingespritzt wird. Das Leiterelement 9 ist in das im Wesentlichen topfförmig ausgebildete Halteelement 7 eingepresst und besteht vorzugsweise aus einem leitenden Kunststoff oder einer metallischen Feder, insbesondere einer Blattfeder oder einer spiralförmigen Druckfeder. Die Unterseite des Leiterelements 9 steht mit der Oberfläche einer Platine 11 mechanisch und mit einem, vorzugsweise mäanderförmig verlaufenden, Kontakt der Platine 11 in Verbindung. Die einzelnen Elemente des Bedienpanels 1 können in üblicher Weise miteinander verbunden sein, beispielsweise durch Klipp-Verbindungen oder Verschrauben oder dergleichen.

Das Leiterelement 9 führt den auf der Platine 11 vorgesehenen elektrischen Kontakt bzw. das betreffende Potential bis an die Oberseite (d.h. den Boden des im Wesentlichen topfförmigen) Leiterelements 9. Die Dicke des Materials zwischen der Oberseite des Leiterelements 9 und der Oberfläche des Blendenteils 5 muss so bemessen sein, dass sich bei einem Berühren des in der Verlängerung der Achse des Leiterelements 9 auf der Oberfläche des Blendenteils 5 vorgesehenen Bedienbereichs noch eine detektierbare Änderung der Kapazität der berührungsempfindlichen Sensortaste ergibt. Das Leiterelement 9 muss dabei so zwischen der Oberfläche der Platine 11 und der Innenwandung des im Wesentlichen topfförmigen Halteelements 7 eingepresst sein, dass sich keine störende Luft als Dielektrikum zwischen Leiterplatte und Leiterelement bzw. zwischen Leiterelement und Halteelement 7 befindet. Denn Luft würde sich als Dielektrikum störend auf die Eigenschaften der Sensortaste 3 auswirken.

In der Oberfläche des Blendenteils 5 ist eine den Bedienbereich 13 umgebende Nut 15 vorgesehen, in welche ein Markierungselement 17 eingesetzt ist. Das Markierungselement 17 kann beispielsweise als ringförmiges Element ausgebildet sein. Es kann jedoch auch als tellerförmiges Element gestaltet sein, an dessen Randbereich ein umlaufender Wulst vorgesehen ist, der in die Nut 15 eingreift.

Die Nut 15 kann, wie bereits vorstehend ausgeführt, mittels eines entsprechenden, beispielsweise ringförmigen oder tellerförmigen Elements hergestellt werden, welches in die Spritzform eines entsprechenden Werkzeugs eingesetzt wird. Auf diese Weise lässt sich das Werkzeug variabel zur Herstellung unterschiedlichster Blendenteile einsetzen.

Wird in der Spritzform ein tellerförmiges Element zur Erzeugung der Nut eingesetzt, so kann damit auch der Bedienbereich 13 gegenüber der übrigen Oberfläche des Blendenteils 5 vertieft oder muldenförmig gestaltet werden.

An der Unterseite des Blendenteils 5 ist das Halteelement 7 angeordnet. Dieses kann an der Oberseite mehrere, beispielsweise drei Nasen 19 aufweisen, die sich bis in die Nut 15 oder dicht bis unmittelbar an die Unterseite der Nut 15 heran erstrecken.

Das Halteelement 7 kann zumindest im Bereich der Nasen aus transparentem Material bestehen. Gleichzeitig kann die Wandung des Halteelements 7 in axialer Fortsetzung einen Einschnitt 7a aufweisen.

Auf diese Weise ist es möglich, über den Einschnitt 7a von der Unterseite der aus Halteelement 7 und Blendenteil 5 bestehenden Einheit her einen Laserstrahl L in den transparenten Bereich des Halteelements 7 im Bereich der Nase 19 einzukoppeln, wobei das Laserlicht den optisch transparenten Bereich durchläuft und erst durch das optisch nicht transparente Material des Markierungselements 7 oder der restlichen Wandung des Blendenteils 5 zwischen der Nase 19 und dem Markierungselement 17 absorbiert wird. Infolge der Absorption der optischen Leistung schmilzt das betreffende Material auf bzw. wird erweicht, so dass nach dem Abschalten des Laserlichts und dem Erstarren des Materials eine Schweißverbindung hergestellt ist. Das Verschweißen kann, wie bereits vorstehend erwähnt, an mehreren, beispielsweise drei Punkten erfolgen.

Auf diese Weise ist das Markierungselement 17 fest mit dem Blendenteil 5 verbindbar. Aus Gründen einer möglichst einfachen Herstellung wird man dabei selbstverständlich das Halteelement 7 insgesamt aus einem transparenten Material herstellen. Bei Wahl eines optisch ausreichend transparenten Materials für das Halteelement 7 kann auch auf die Einschnitte 7a verzichtet werden, wobei das Halteelement 7 in diesem Fall auch als Licht leitendes Element für den Laser-Schweißstrahl dienen kann.

Fig. 2 zeigt die Herstellung eines sehr ähnlichen Bedienpanels 1, jedoch mit einem unterschiedlichen Schweißverfahren, nämlich dem Ultraschallschweißen. Das Blendenteil 5 und das Halteelement 7 können in diesem Fall aus ein und demselben Material bestehen und als einstückiges Element in einem Schweißvorgang erzeugt werden. Im Übrigen ist das Bedienpanel 1 praktisch identsich ausgebildet wie bei der Ausführungsform gemäß Fig. 1.

Zur Realisierung des Ultraschallschweißens ist es jedoch vorteilhaft, an der Unterseite des Markierungselements 17 einen Schweißwulst 17a oder mehrere Schweißnasen vorzusehen. Zur Verbindung des Markierungselements 17 mit dem Blendenteil 5 wird das Markierungselement 17 in die Nut 15 eingesetzt, so dass der Schweißwulst 17a auf dem Boden der Nut 15 aufliegt. Auf das Markierungselement 17 kann dann der Ultraschallstempel aufgesetzt werden, so dass sich durch eine Ultraschall-Vibration des Markierungselements 17 der Schweißwulst 17a infolge der erzeugten Reibungswärme erhitzt und das Material in diesem Bereich erweicht wird bzw. aufschmilzt.

Selbstverständlich sind auch andere Möglichkeiten zur Verbindung des Markierungselements 17 und des Blendenteils 5 möglich, beispielsweise ein Verkleben, Verrasten oder Einpressen des Markierungselements 17 in die Nut 15.

## Patentansprüche

1. Verfahren zur Herstellung eines Blendenteils für ein Bedienpanel mit berührungsempfindlichen Sensortasten, insbesondere für ein Haushaltsgerät, bei dem auf der Oberfläche des Blendenteils (5) wenigstens ein Bedienbereich (13) für eine berührungsempfindliche Sensortaste (3) vorgesehen ist, wobei für das Kenntlich-Machen des Umrisses des Bedienbereichs (13) wenigstens ein Markierungselement (17) mit der Oberfläche des Blendenteils (5) nach dessen Herstellung verbunden wird und in der Oberfläche des Blendenteils (5) eine Nut (15) vorgesehen ist, in welche das wenigstens eine Markierungselement (17) eingesetzt wird, **dadurch gekennzeichnet, dass** das Verbinden des wenigstens einen Markierungselements (17) mit der Oberfläche des Blendenteils (5) durch Verschweißen mit der die Nut (15) bildenden Wandung, vorzugsweise dem bodenseitigen Bereich der Wandung erfolgt, und dass das Blendenteil (5) an der dem Bedienbereich (13) abgewandten Seite einen optisch transparenten Bereich (19) aufweist, der sich zumindest in einem Teilbereich im Wesentlichen bis an die Wandung der Oberfläche des Blendenteils (5) erstreckt, in welchem die Schweißverbindung hergestellt wird.

2. Verfahren nach Anspruch 1, **dadurch gekennzeichnet, dass** in der Oberfläche des Blendenteils (5) mehrere Nuten (15) vorgesehen sind, wobei lediglich in die Nuten (15) der Bedienbereiche (13) der tatsächlich benötigten Sensortasten Markierungselemente (17) eingesetzt werden, und in die übrigen Nuten (15) Blindelemente eingesetzt werden, die insbesondere an der Oberfläche dieselbe Farbe wie das übrige Blendenteil aufweisen und die insbesondere nach dem Einsetzen mit der Oberfläche des Blendenteils fluchten.

3. Verfahren nach einem der Ansprüche 1 oder 2, **dadurch gekennzeichnet, dass** die Nut (15) den Bedienbereich (13) als vorzugsweise geschlossene Nut umgibt.

4. Verfahren nach einem der Ansprüche 1 bis 3, **dadurch gekennzeichnet, dass** das Verschweißen durch Ultraschallschweißen erfolgt und dass vorzugsweise an der in die Nut (15) eingreifenden Unterseite des wenigstens einen Blendenteils (5) ein Schweißwulst (17a) vorgesehen ist.

5. Verfahren nach einem der Ansprüche 1 bis 3, **dadurch gekennzeichnet, dass** das Verschweißen durch Laserschweißen erfolgt.

6. Verfahren nach Anspruch 5, **dadurch gekennzeichnet, dass** das Laserschweißen durch die Einkopplung eines Laserstrahls (L) in den transparenten Bereich (19) hergestellt wird, wobei das wenigstens eine Markierungselement (17) und/oder das Blendenteil (5) im Bereich der restlichen Wandstärke zwischen dem wenigstens einen Markierungselement (17) und dem optisch transparenten Bereich (19) aus einem das Laserlicht absorbierenden Material besteht, so dass dieses Material geschmolzen oder erweicht wird und nach dem Erstarren die Schweißverbindung gebildet wird.

7. Blendenteil für ein Bedienpanel mit berührungsempfindlichen Sensortasten, insbesondere für ein Haushaltsgerät, bei dem auf der Oberfläche des Blendenteils (5) wenigstens ein Bedienbereich (13) für eine berührungsempfindliche Sensortaste (3) vorgesehen ist, wobei für das Kenntlich-Machen des Umrisses des Bedienbereichs (13) wenigstens ein Markierungselement (17) mit der Oberfläche des Blendenteils (5) nach dessen Herstellung verbunden ist, **dadurch gekennzeichnet, dass** in der Oberfläche des Blendenteils (5) mehrere Nuten (15) vorgesehen sind, wobei lediglich in die Nuten (15) der Bedienbereiche (13) der tatsächlich benötigten Sensortasten Markierungselemente (17) eingesetzt sind, und in die übrigen Nuten (15) Blindelemente eingesetzt sind, die insbesondere an der Oberfläche dieselbe Farbe wie das übrige Blendenteil aufweisen und die insbesondere nach dem Einsetzen mit der Oberfläche des Blendenteils fluchten.

8. Blendenteil nach Anspruch 7, **dadurch gekennzeichnet, dass** die Nut (15) den Bedienbereich (13) als vorzugsweise geschlossene Nut umgeben ist.

9. Blendenteil nach Anspruch 7 oder 8, **dadurch gekennzeichnet, dass** das wenigstens eine Markierungselement (17) mit der Oberfläche des Blendenteils (5) durch eine Rastverbindung des Markierungselements (17) mit der Nut (15) verbunden ist.

10. Blendenteil nach einem der Ansprüche 7 bis 9, **dadurch gekennzeichnet, dass** das wenigstens eine Markierungselement (17) mit der Oberfläche des Blendenteils (5) durch Verkleben mit der die Nut (15) bildenden Wandung, vorzugsweise dem bodenseitigen Bereich der Wandung verbunden ist.

11. Blendenteil nach einem der Ansprüche 7 bis 9, **dadurch gekennzeichnet, dass** das wenigstens eine Markierungselement (17) mit der Oberfläche des Blendenteils (5) durch Verschweißen mit der die Nut (15) bildenden Wandung, vorzugsweise dem bodenseitigen Bereich der Wandung verbunden ist.

12. Blendenteil nach Anspruch 11, **dadurch gekennzeichnet, dass** das Verschweißen durch Ultraschallschweißen erfolgt ist und dass vorzugsweise an der in die Nut (15) eingreifenden Unterseite des wenigstens einen Blendenteils (5) ein Schweißwulst (17a) vorgesehen ist.

13. Blendenteil nach Anspruch 11, **dadurch gekennzeichnet, dass** das Verschweißen durch-Laserschweißen erfolgt ist.

14. Blendenteil nach Anspruch 12 oder 13, **dadurch gekennzeichnet, dass** das Blendenteil (5) an der dem Bedienbereich (13) abgewandten Seite einen optisch transparenten Bereich (19) aufweist, der sich zumindest in einem Teilbereich im Wesentlichen bis an die Wandung der Oberfläche des Blendenteils (5) erstreckt, in welchem die Schweißverbindung hergestellt ist.

15. Blendenteil nach Anspruch 14, **dadurch gekennzeichnet, dass** das Laserschweißen durch die Einkopplung eines Laserstrahls (L) in den transparenten Bereich (19) herstellbar ist, wobei das wenigstens eine Markierungselement (17) und/oder das Blendenteil (5) im Bereich der restlichen Wandstärke zwischen dem wenigstens einen Markierungselement (17) und dem optisch transparenten Bereich (19) aus einem das Laserlicht absorbierenden Material besteht, so dass dieses Material beim Laserschweißen geschmolzen oder erweicht wird und nach dem Erstarren die Schweißverbindung bildet.

## Claims

1. Method for producing a panel member for a control panel with touch-sensitive sensor buttons, particularly for a domestic appliance, in which at least one operating zone (13) for a touch-sensitive sensor button (3) is provided on the surface of the panel member (5), wherein for making the outline of the operating zone (13) recognisable at least one marking element (17) is connected with the surface of the panel member (5) after production thereof and provided in the surface of the panel member (5) is a groove (15) into which the at least one marking element (17) is inserted, **characterised in that** the connection of the at least one marking element (17) with the surface of the panel member (5) is carried out by welding to the wall, preferably the region of the wall at the bottom, forming the groove (15) and that the panel member (5) has at the side remote from the operating zone (13) an optically transparent region (19) extending at least in a sub-region substantially up to the wall of the surface of the panel member (5) in which the weld connection is produced.

2. Method according to claim 1, **characterised in that** several grooves (15) are provided in the surface of the panel member (5), wherein marking elements (17) are inserted only in the grooves (15) of the operating zones (13) of the actually required sensor buttons, and blanking elements are inserted in the remaining grooves (15), which blanking elements have in particular the same colour at the surface as the rest of the panel member and in particular after insertion align with the surface of the panel part.

3. Method according to one of claims 1 and 2, **characterised in that** the groove (15) surrounds the operating zone (13) as a preferably closed groove.

4. Method according to any one of claims 1 to 3, **characterised in that** the welding is carried out by ultrasonic welding and that a weld bead (17a) is preferably provided at the underside, which engages in the groove (15), of the at least one panel member (5)

5. Method according to any one of claims 1 to 3, **characterised in that** the welding is carried out by laser welding.

6. Method according to claim 5, **characterised in that** the laser welding is produced by coupling a laser beam (L) into the transparent region (19), wherein the at least one marking element (17) and/or the panel member (5) in the region of the residual wall thickness between the at least one marking element (17) and the optically transparent region (19) consists of a material absorbing the laser light so that this material is melted or softened and the weld connection is formed after hardening.

7. Panel member for a control panel with touch-sensitive sensor buttons, particularly for a domestic appliance, in which at least one operating zone (13) for a touch-sensitive sensor button (3) is provided on the surface of the panel member (5), wherein for making the outline of the operating zone (13) recognisable at least one marking element (16) is connected with the surface of the panel member (5) after production thereof, **characterised in that** several grooves (15) are provided in the surface of the panel member (5), wherein marking elements (17) are inserted only in the grooves (15) of the operating zones (13) of the actually required sensor buttons and blanking elements are inserted in the remaining grooves (15), which blanking elements have in particular the same colour at the surface as the rest of the panel member and in particular after insertion align with the surface of the panel member.

8. Panel member according to claim 7, **characterised in that** the groove (15) surrounds the operating zone (13) as a preferably closed groove.

9. Panel member according to claim 7 or 8, **characterised in that** the at least one marking element (17) is connected with the surface of the panel member (5) by a detent connection of the marking element (17) with the groove (15).

10. Panel member according to any one of claims 7 to 9, **characterised in that** the at least one marking element (17) is connected with the surface of the panel member (5) by gluing with the wall forming the groove (15), preferably with the region of the wall at the bottom.

11. Panel member according to any one of claims 7 to 9, **characterised in that** the at least one marking element (17) is connected with the surface of the panel member (5) by welding to the wall forming the groove (15), preferably the region of the wall at the bottom.

12. Panel member according to claim 11, **characterised in that** the welding is carried out by ultrasonic welding and that a weld bead (17a) is provided preferably at the underside, which engages in the groove (15), of the at least one panel member (5).

13. Panel member according to claim 11, **characterised in that** the welding is carried out by laser welding.

14. Panel member according to claim 12 or 13, **characterised in that** the panel member (5) has at the side remote from the operating zone (13) an optically transparent region (19) extending at least in a sub-region substantially up to the wall of the surface of the panel member (5) in which the weld connection is produced.

15. Panel member according to claim 14, **characterised in that** the laser welding is producible by coupling of a laser beam (L) into the transparent region (19), wherein the at least one marking element (17) and/or the panel member (5) in the region of the residual wall thickness between the at least one marking element (17) and the optically transparent region (19) consists of a material absorbing laser light so that this material is melted or softened during the laser welding and forms the weld connection after hardening.

## Revendications

1. Procédé pour la fabrication d'une partie d'écran pour un panneau de commande comprenant des touches de capteur à effleurement tactile, notamment pour un appareil ménager, dans lequel au moins une zone de commande (13) est prévue sur la surface de la partie d'écran (5) pour une touche de capteur (3) à effleurement tactile, au moins un élément de marquage (17) étant relié avec la surface de la partie d'écran (5) après sa fabrication pour la caractérisation du contour de la zone de commande (13) et une rainure (15) étant prévue dans la surface de la partie d'écran (5), rainure dans laquelle l'au moins un élément de marquage (17) est inséré, **caractérisé en ce que** la liaison de l'au moins un élément de marquage (17) avec la surface de la partie d'écran (5) s'effectue par soudage avec la paroi formant la rainure (15), de préférence la zone côté fond de la paroi, et **en ce que** la partie d'écran (5) présente sur le côté opposé à la zone de commande (13) une zone (19) optiquement transparente, qui s'étend au moins dans une zone partielle essentiellement jusqu'à la paroi de la surface de la partie d'écran (5) dans laquelle la liaison soudée est étable.

2. Procédé selon la revendication 1, **caractérisé en ce que** plusieurs rainures (15) sont prévues dans la surface de la partie d'écran (5), des éléments de marquage (17) étant insérés uniquement dans les rainures (15) des zones de commande (13) des touches de capteur réellement utilisées, et des éléments aveugles étant insérés dans les autres rainures (15), lesquels présentent en particulier sur la surface la même couleur que la partie d'écran restante et qui sont alignés en particulier après l'insertion avec la surface de la partie d'écran.

3. Procédé selon l'une quelconque des revendications 1 à 2, **caractérisé en ce que** la rainure (15) entoure la zone de commande (13) sous forme de rainure de préférence fermée.

4. Procédé selon l'une quelconque des revendications 1 à 3, **caractérisé en ce que** le soudage s'effectue par soudage aux ultrasons et **en ce qu'**un renflement de soudage (17a) est prévu de préférence sur le côté inférieur, s'engageant dans la rainure (15), de l'au moins une partie d'écran (5).

5. Procédé selon l'une quelconque des revendications 1 à 3, **caractérisé en ce que** le soudage s'effectue par soudage au laser.

6. Procédé selon la revendication 5, **caractérisé en ce que** le soudage au laser est effectué par l'injection d'un faisceau laser (L) dans la zone (19) transparente, l'au moins un élément de marquage (17) et/ou la partie d'écran (5) étant à base d'un matériau absorbant la lumière laser dans la zone de l'épaisseur de paroi restante entre l'au moins un élément de marquage (17) et la zone (19) optiquement transparente, de sorte que ce matériau est fondu et la liaison soudée est formée après la solidification.

7. Partie d'écran pour un panneau de commande avec des touches de capteur à effleurement tactile, en particulier pour un appareil ménager, sur laquelle au moins une zone de commande (13) est prévue sur la surface de la partie d'écran (5) pour une touche de capteur (3) à effleurement tactile, au moins un élément de marquage (17) étant relié à la surface de la partie d'écran (5) après sa fabrication pour la caractérisation du contour de la zone de commande (13), **caractérisée en ce que** plusieurs rainures (15) sont prévues dans la surface de la partie d'écran (5), des éléments de marquage (17) étant insérés uniquement dans les rainures (15) des zones de commande (13) des touches de capteur réellement utilisées et des éléments aveugles étant insérés dans les autres rainures (15), lesquels présentent en particulier sur la surface la même couleur que la partie d'écran restante et qui sont alignés en particulier après l'insertion avec la surface de la partie d'écran.

8. Partie d'écran selon la revendication 7, **caractérisée en ce que** la rainure (15) est entourée par la zone de commande (13) sous forme de rainure de préférence fermée.

9. Partie d'écran selon la revendication 7 ou 8, **caractérisée en ce que** l'au moins un élément de marquage (17) est relié avec la surface de la partie d'écran (5) par une liaison à encliquetage de l'élément de marquage (17) à la rainure (15).

10. Partie d'écran selon l'une quelconque des revendications 7 à 9, **caractérisée en ce que** l'au moins un élément de marquage (17) est relié avec la surface de la partie d'écran (5) par collage avec la paroi formant la rainure (15), de préférence la zone côté fond de la paroi.

11. Partie d'écran selon l'une quelconque des revendications 7 à 9, **caractérisée en ce que** l'au moins un élément de marquage (17) est relié avec la surface de la partie d'écran (5) par soudage avec la paroi formant la rainure (15), de préférence la zone côté fond de la paroi.

12. Partie d'écran selon la revendication 11, **caractérisée en ce que** le soudage s'effectue par soudage aux ultrasons et **en ce qu'**un renflement de soudage (17a) est prévu de préférence sur le côté inférieur, s'engageant dans la rainure (15), de l'au moins une partie d'écran (5).

13. Partie d'écran selon la revendication 11, **caractérisée en ce que** le soudage est effectué par soudage au laser.

14. Partie d'écran selon la revendication 12 ou 13, **caractérisée en ce que** la partie d'écran (5) présente sur le côté opposé à la zone de commande (13) une zone (19) optiquement transparente, qui s'étend au moins dans une zone partielle essentiellement jusqu'à la paroi de la surface de la partie d'écran (5) dans laquelle la liaison soudée est établie.

15. Partie d'écran selon la revendication 14, **caractérisée en ce que** le soudage au laser peut être effectué par l'injection d'un faisceau laser (L) dans la zone (19) transparente, l'au moins un élément de marquage (17) et/ou la partie d'écran (5) étant à base d'un matériau absorbant la lumière laser dans la zone de l'épaisseur de paroi restante entre l'au moins un élément de marquage (17) et la zone (19) optiquemment transparente, de sorte que ce matériau est fondu ou ramolli lors du soudage au laser et forme la liaison soudée après la solidification.
